# EUROPEAN PATENT SPECIFICATION

(11) **EP 3 070 748 B1**
(45) Date of publication and mention of the grant of the patent: **25.07.2018**
(21) Application number: 14859723.0
(22) Date of filing: 30.10.2014
(51) Int. Cl.: H01L 31/048, C09J 183/04

(54) **SILICONE ADHESIVE SHEET HAVING ULTRAVIOLET RAY SHIELDING PROPERTIES FOR SEALING SOLAR CELL AND SOLAR CELL MODULE USING SAME**
SILIKONHAFTFOLIE MIT UV-STRAHLENABSCHIRMENDEN EIGENSCHAFTEN ZUM ABDICHTEN EINER SOLARZELLE UND SOLARZELLENMODUL DAMIT
FEUILLE D'ADHÉSIF À BASE DE SILICONE AYANT DES PROPRIÉTÉS DE BLINDAGE CONTRE UN RAYONNEMENT ULTRAVIOLET POUR SCELLER DE MANIÈRE ÉTANCHE UNE PHOTOPILE ET MODULE DE PHOTOPILES L'UTILISANT

(30) Priority: 11.11.2013 JP 2013232886
(43) Date of publication of application: 21.09.2016
(73) Proprietor: Shin-Etsu Chemical Co., Ltd., Tokyo 100-0004 (JP)
(72) Inventor: YAMAKAWA, Naoki, Annaka-shi Gunma 379-0224 (JP); IGARASHI, Minoru, Annaka-shi Gunma 379-0224 (JP); YAGINUMA, Atsushi, Annaka-shi Gunma 379-0224 (JP); FURIHATA, Tomoyoshi, Annaka-shi Gunma 379-0224 (JP); OHWADA, Hiroto, Annaka-shi Gunma 379-0224 (JP); TSUKADA, Junichi, Annaka-shi Gunma 379-0224 (JP); ITO, Atsuo, Tokyo 100-0004 (JP)
(74) Representative: Ter Meer Steinmeister & Partner
(86) International application number: PCT/JP2014/078872
(87) International publication number: WO 2015/068633

(56) References cited:
- WO-A1-2010/067803
- JP-A- 2009 010 097
- JP-A- 2009 290 201
- JP-A- 2011 116 014
- JP-A- 2012 071 502
- JP-A- 2012 200 981
- JP-A- 2013 056 543
- JP-A- 2013 058 747
- JP-A- 2013 145 807
- US-A1- 2012 055 539
- US-A1- 2013 240 034

## Description

### TECHNICAL FIELD

This invention relates to a silicone adhesive sheet useful for reliably encapsulating crystalline or polycrystalline solar cells in which the back surface panel is, in particular, a polyethylene terephthalate (PET)-containing backsheet. The invention relates also to a solar cell module using such a silicone adhesive sheet.

### BACKGROUND ART

In recent years, photovoltaic power generation has attracted growing interest as an energy resource that utilizes sunlight. Here, the power-generating element in a solar cell is generally composed of a semiconductor such as silicon. In a solar cell module, individual solar cells are typically placed, in an electrically interconnected state, on a glass substrate on the light-receiving surface of the module.

The solar cell is protected from the ambient environment, including rain, wind, snow and dust, by covering the front surface of the solar cell on which sunlight falls and the back surface with an encapsulant. Ethylene-vinyl acetate copolymer (EVA), a type of thermoplastic resin, is generally used as the encapsulant because it is easy to handle in sheet form and is inexpensive. The method generally used to fabricate a module from solar cells using EVA involves setting a light-receiving surface panel/EVA sheet/solar cell/EVA sheet/back panel (backsheet) stack in a vacuum laminator and pressing the stack at 130 to 150°C for 15 to 30 minutes.

However, when EVA is used as the encapsulant, acetic acid is generated, especially in a hot humid environment. The generated acetic acid causes corrosion of the solar cell electrodes and other undesirable effects, leading to a deterioration in photovoltaic performance. Because solar cells are expected to be in service for a long period of time measured in decades, from a warranty standpoint, a prompt solution to the problem of degradation over time is needed.

The problems with EVA are not limited to this alone. EVA also has a low UV resistance and discolors on long-term outdoor exposure, turning yellow or brown and thus marring the appearance.

One encapsulant that is free of such drawbacks is silicone. For example, when silicone is used as the encapsulant, it does not generate acetic acid. Hence, not only can electrode corrosion be minimized, the problem of yellow or brown discoloration is also eliminated. Moreover, unlike EVA, there is no sudden rise in elastic modulus at low temperatures, and so the electrode connections are more reliable. For example, Non-Patent Document 1 (A. Ito, H. Owada, T. Furihata, T. Kim, N. Yamakawa, A. Yaginuma, T. Imataki, M. Watanabe, and S. Sakamoto: Preprints of 9th Next-Generation Photovoltaic System Symposium, p. 54 (2012)) reports that silicone-encapsulated solar cell modules which had received 29 years of outdoor exposure were re-evaluated and found to have a very high reliability, the decline in maximum output being a mere -0.22%/year.

Silicone has an excellent heat resistance and UV resistance, and has been widely used recently as an encapsulant for light-emitting diodes (LEDs). It is characterized by having a high transmittance not only to visible light, but also to blue light (450 to 495 nm) and violet light (380 to 450 nm).

Yet, in spite of the fact that silicone, compared to EVA, has a high weather resistance, a high transmittance to short-wavelength light and a high photovoltaic output, it is not always favorable for use in solar cells.

The production volume and installed capacity of solar cells is rising rapidly worldwide. Such growth is accompanied by a strong desire for lower costs.

Generally, in a "superstrate" type solar cell module, the solar cells are encapsulated using EVA as the encapsulant between glass on the light-receiving surface and a backsheet. The backsheet has a thickness of 150 to 350 µm, and is situated so as to provide long-term protection of the solar cells and wiring members from outside environmental stress. Properties desired of the backsheet include high water vapor barrier properties, electrical insulating properties and light reflectivity. Typical commercially available products include laminates referred to as "TPT" (polyvinyl fluoride (PVF)/adhesive/polyethylene terephthalate (PET)/adhesive/PVF) and "TPE" (PVF/adhesive/PET/adhesive/EVA), and also resin laminates with aluminum foil sandwiched therein that completely shuts out water vapor.

Cost reductions in the backsheet have been achieved in recent years, and PET single-layer sheets that do not use fluoroplastics such as PVF have even appeared. When the encapsulant is EVA, short-wavelength light is absorbed owing to the effect of ultraviolet absorbents added thereto, and so the influence on the PET is small. However, when a silicone encapsulant that transmits also short-wavelength light is used, deterioration soon occurs. A fluoroplastic is expected not only to have the ability to prevent soiling, but also to be able to cut UV transmission and thus protect against deterioration of the PET core material. Hence, employing a silicone encapsulant in a low-cost backsheet that does not contain such a fluoroplastic has been a challenge.

Various encapsulation methods have been studied in order to obtain silicone-encapsulated solar cells. Patent Document 1 (JP-A 2007-527109) describes the placement, using a multi-axis robot, of connected solar cells on or in a liquid silicone material coated onto a substrate, followed by curing of the silicone material, thereby achieving encapsulation without the entrapment of air bubbles. Patent Document 2 (JP-A 2011-514680) describes the placement, using a cell press having a movable plate, of solar cells on cured or semi-cured silicone within a vacuum, thereby achieving encapsulation without entrapping air bubbles. In addition, Patent Document 3 (WO 2009/091068) discloses a method in which an encapsulant, solar cells, a liquid silicone substance and, last of all, a back surface-protecting substrate, are successively placed on a glass substrate to form a preliminary stack which is then bonded under applied pressure at room temperature in a vacuum and thereby sealed. However, it is thought that this latter approach would be difficult to scale to a practical size for solar cell modules. Also Patent Document 4 (US 2012/0055539 A1) discloses silicon-encapsulated solar cells where the silicone resin of the back substrate presents a low light transmittance.

All of these methods include the troublesome operation of coating or potting liquid silicone in the solar cell encapsulating step. Because such an operation would require manufacturers who currently use EVA sheets in the fabrication of solar cell modules to invest in new equipment, these methods are unlikely to be adopted. In Patent Document 2 (JP-A 2011-514680), a pigment may be included in cases where there is no need for the encapsulant to transmit light, although this is not necessarily applicable to low-cost backsheets. Moreover, because cured products obtained using a low-viscosity silicone ideal for coating or potting have a low physical strength compared with EVA and also have a low adhesive strength, there has been a desire for the development of a silicone encapsulant of higher physical strength and higher adhesive strength.

### SUMMARY OF THE INVENTION

### PROBLEMS TO BE SOLVED BY THE INVENTION

This invention was arrived at in view of the above circumstances and relates in particular to a silicone encapsulant which, even when a backsheet that does not include a fluoroplastic is used, keeps the backsheet from deteriorating due to ultraviolet light. The object of the invention is to provide a UV-shielding silicone adhesive sheet for solar cell encapsulation which is in the form of a sheet rather than a liquid and is thus easy to handle, and a solar cell module made therewith.

### MEANS FOR SOLVING THE PROBLEMS

The inventors have conducted extensive investigations, as a result of which they have discovered that by producing an integral laminate in which the solar cells are disposed between the two adhesive sheets of, respectively, a back surface laminate of a UV-shielding silicone adhesive sheet formed of a silicone rubber adhesive composition that shields in particular light having wavelengths of 380 nm or less on a backsheet, and a light-receiving surface laminate of the same or a different silicone adhesive sheet on a light-receiving surface panel, and then pressing the integral laminate under heating in a vacuum, handling is easy, the encapsulating properties are good and, even when a low-cost backsheet is used, degradation of the surface PET by ultraviolet light can be prevented.

Accordingly, the invention provides the following UV-shielding silicone adhesive sheet for encapsulating solar cells that forms a solar cell module as claimed, and a solar cell module using the same according to the claims.

### ADVANTAGEOUS EFFECTS OF THE INVENTION

The silicone adhesive sheet of the invention is a millable type adhesive sheet that can be extruded or calendered. A laminate of a light-receiving surface panel, a silicone adhesive sheet, solar cells, a silicone adhesive sheet according to the invention and a back panel (backsheet) can be formed into a module using a vacuum laminator. This enables a module which has good cell encapsulating properties and can prevent deterioration of the backsheet by ultraviolet light to be easily and conveniently obtained without the use of conventional liquid silicone.

### BRIEF DESCRIPTION OF THE DIAGRAMS

[FIG. 1] FIG. 1 is a schematic cross-sectional view of a solar cell module according to one embodiment of the invention.
[FIG. 2] FIG. 2 is a schematic cross-sectional view of a solar cell module according to another embodiment of the invention.
[FIG. 3] FIG. 3 is a schematic cross-sectional view showing an example of the laminate that is set in a vacuum laminator in the working examples of the invention.
[FIG. 4] FIG. 4 is a schematic cross-sectional view of a solar cell module in the comparative example.
[FIG. 5] FIG. 5 is a graph showing the relationship between the wavelength of light and the light transmittance of the UV-shielding cured silicone adhesive sheet in Example 2.
[FIG. 6] FIG. 6 is a graph showing the relationship between the wavelength of light and the light transmittance of the UV-shielding cured silicone adhesive sheet in the comparative example.

### EMBODIMENT FOR CARRYING OUT THE INVENTION

The UV-shielding silicone adhesive sheet of the invention can prevent the deterioration by ultraviolet light of the PET serving as a member of the backsheet. The transmittance to 380 nm light of the silicone adhesive layer situated above the backsheet is therefore set to 30% or less, which is comparable to the transmittance of EVA for solar cell encapsulation. At a transmittance to 380 nm light greater than 30%, the backsheet (PET) may be degraded by the ultraviolet component of sunlight. On the other hand, the lower the transmittance to 380 nm light the more desirable.

The UV-shielding silicone adhesive sheet of the invention is obtained by calendering, extruding or otherwise processing into sheet form a silicone rubber composition containing either
(A) 100 parts by weight of an organopolysiloxane of the formula

   R¹ₐSiO_{(4-a)/2} (I)

   (wherein each R¹, which is the same or different, an unsubstituted or substituted monovalent hydrocarbon group, and "a" is a positive number from 1.95 to 2.05) having a degree of polymerization of at least 100,
(B) 10 to 150 parts by weight of reinforcing silica having a specific surface area of more than 200 m²/g,
(C) a curing agent in an amount effective for curing component (A),
(D) 0 to 10 parts by weight of a tackifier, and
(E) 0.1 to 50 parts by weight of a filler having an average particle size of 0.1 to 10 µm (exclusive of component (B)); or
(A) 100 parts by weight of an organopolysiloxane of the formula

   R¹ₐSiO_{(4-a)/2} (I)

   (wherein each R¹, which is the same or different, an unsubstituted or substituted monovalent hydrocarbon group, and "a" is a positive number from 1.95 to 2.05) having a degree of polymerization of at least 100,
(B) 10 to 150 parts by weight of reinforcing silica having a specific surface area of more than 200 m²/g,
(C) a curing agent in an amount effective for curing component (A),
(D) 0 to 10 parts by weight of a tackifier, and
(F) 0.05 to 2 parts by weight of an ultraviolet absorber.

Therefore, the sheet is in an uncured state.

The silicone rubber composition is described in detail below.

In the silicone rubber composition of the invention, component (A) is an organopolysiloxane of the average compositional formula (I) below

R¹ₐSiO_{(4-a)/2} (I)

(wherein each R¹, which is the same or different, an unsubstituted or substituted monovalent hydrocarbon group, and "a" is a positive number from 1.95 to 2.05) having a degree of polymerization of at least 100.

In average compositional formula (I), each R¹, which is the same or different, an unsubstituted or substituted monovalent hydrocarbon group having typically 1 to 12 carbon atoms, and preferably 1 to 8 carbon atoms. Examples include alkyl groups such as methyl, ethyl, propyl, butyl, hexyl and octyl groups; cycloalkyl groups such as cyclopentyl and cyclohexyl groups; alkenyl groups such as vinyl, allyl and propenyl groups; cycloalkenyl groups; aryl groups such as phenyl and tolyl groups; aralkyl groups such as benzyl and 2-phenylethyl groups; and any of these groups in which some or all of the hydrogen atoms have been substituted with halogen atoms or cyano groups. Methyl, vinyl, phenyl and trifluoropropyl groups are preferred, with methyl and vinyl groups being especially preferred.

Suitable examples of the organopolysiloxane include organopolysiloxanes in which the main chain consists of repeating dimethylsiloxane units; and organopolysiloxanes in which diphenylsiloxane units, methylphenylsiloxane units, methylvinylsiloxane units, methyl-3,3,3-trifluoropropyl-siloxane units or the like which contain, for example, phenyl, vinyl or 3,3,3-trifluoropropyl groups have been inserted into portions of the dimethylpolysiloxane structure consisting of repeating dimethylsiloxane units that makes up the main chain.

Organopolysiloxanes having two or more aliphatic unsaturated groups such as alkenyl or cycloalkenyl groups per molecule are preferred, and organopolysiloxanes having vinyl groups are especially preferred. It is preferable for 0.01 to 20 mol %, and especially 0.02 to 10 mol %, of all the R¹ groups to be aliphatic unsaturated groups. These aliphatic unsaturated groups may be bonded to silicon atoms at the ends of the molecular chain, may be bonded to silicon atoms partway along the molecular chain, or may be bonded to silicon atoms in both such places, although it is preferable for the aliphatic unsaturated groups to be bonded to at least the silicon atoms at the ends of the molecular chain. The subscript "a" is a positive number from 1.95 to 2.05, preferably from 1.98 to 2.02, and more preferably from 1.99 to 2.01.

Preferred examples of the organopolysiloxane serving as component (A) include those in which the ends of the molecular chain are capped with triorganosiloxy groups such as trimethylsiloxy, dimethylphenylsiloxy, dimethylhydroxysiloxy, dimethylvinylsiloxy, methyldivinylsiloxy or trivinylsiloxy groups.

Especially preferred examples include methylvinylpolysiloxane, methylphenylvinylpolysiloxane and methyltrifluoropropylvinylpolysiloxane.

Such organopolysiloxanes may be obtained by (co)hydrolyzing/condensing one, two or more types of organohalogenosilane, or by the ring-opening polymerization of a cyclic polysiloxane (such as a siloxane trimer or tetramer) using an alkaline or acidic catalyst. These are basically straight-chain diorganopolysiloxanes, although a mixture of two, three or more organopolysiloxanes of differing molecular weight (degree of polymerization) and molecular structure may be used as component (A).

The organopolysiloxane has a degree of polymerization of 100 or more, preferably 100 to 100,000, and more preferably 3,000 to 20,000. This degree of polymerization can be measured as the polystyrene-equivalent weight-average degree of polymerization by gel permeation chromatography (GPC).

The reinforcing silica having a BET specific surface area of more than 50 m²/g serving as component (B) is added so as to obtain a rubber composition having excellent mechanical strength before and after curing. Here, in order to improve the transparency of the silicone rubber composition, the BET specific surface area must be greater than 200 m²/g, and is preferably at least 250 m²/g. At a BET specific surface area of 200 m²/g or less, the transparency of the cured composition decreases. The specific surface area has no particular upper limit, but is typically 500 m²/g or less.

Examples of the reinforcing silica serving as component (B) include aerosol silica (dry silica or fumed silica) and precipitated silica (wet silica). Preferred use can be made of such silicas that have been rendered hydrophobic by surface treatment with, for example, chlorosilane, alkoxysilane or hexamethyldisilazane. Treatment with hexamethyldisilazane is especially preferred because it increases the transparency. The use of an aerosol silica as the reinforcing silica is preferred for increasing transparency. One type of reinforcing silica may be used alone, or two or more types may be used together.

A commercial product may be used as the reinforcing silica serving as component (B). Examples include fumed silicas that are not surface treated or that have been rendered hydrophobic by surface treatment (i.e., that are hydrophilic or hydrophobic), including products of the Aerosil series (Nippon Aerosil Co., Ltd.) such as Aerosil 130, Aerosil 200, Aerosil 300, Aerosil R-812, Aerosil R-972 and Aerosil R-974, Cabosil MS-5 and MS-7 (Cabot Corp.), and Reolosil QS-102, 103 and MT-10 (Tokuyama Corp.); and precipitated silicas that are not surface treated or that have been rendered hydrophobic by surface treatment, including Tokusil US-F (Tokuyama Corp.) and NIPSIL-SS and NIPSIL-LP (Nippon Silica).

The reinforcing silica serving as component (B) is included in an amount, per 100 parts by weight of the organopolysiloxane serving as component (A), of from 10 to 150 parts by weight, preferably 30 to 120 parts by weight, and more preferably 50 to 100 parts by weight. When the component (B) content is too low, the reinforcing effects before and after curing may not be obtained and the transparency of the cured silicone adhesive may decrease. When the content is too high, the silica may not readily disperse within the silicone polymer and processability of the composition into sheet form may worsen.

The curing agent serving as component (C) is not particularly limited so long as it can cure component (A), although preferred use can be made of a well-known silicone rubber curing agent, such as (a) an addition reaction (hydrosilylation) type curing agent, this being a combination of an organohydrogenpolysiloxane (crosslinker) and a hydrosilylation catalyst, or (b) an organic peroxide.

The organohydrogenpolysiloxane serving as the crosslinker in (a) the addition reaction (hydrosilylation) type curing agent may be a known organohydrogenpolysiloxane which has at least two silicon-bonded hydrogen atoms (SiH groups) per molecule and is represented by the following average compositional formula (II).

R²_{b}H_{c}SiO_{(4-b-c)/2} (II)

(In the formula, R² is an unsubstituted or substituted monovalent hydrocarbon group of 1 to 6 carbon atoms and preferably does not have an aliphatic unsaturated bond. Examples include alkyl groups such as methyl, ethyl, propyl, butyl, pentyl and hexyl groups; monovalent hydrocarbon groups such as cyclohexyl, cyclohexenyl and phenyl groups; and substituted monovalent hydrocarbon groups such as substituted alkyl groups in which at least some of the hydrogen atoms on the above monovalent hydrocarbon groups are substituted with halogen atoms or cyano groups, such as 3,3,3-trifluoropropyl and cyanomethyl groups. Also, the subscript "b" is a positive number from 0.7 to 2.1, the subscript "c" is a positive number from 0.01 to 1.0 and the sum b+c is a positive number from 0.8 to 3.0, with b being preferably from 0.8 to 2.0, c being preferably from 0.2 to 1.0 and b+c being preferably from 1.0 to 2.5.)
The organohydrogenpolysiloxane has a molecular structure which may be linear, cyclic, branched or a three-dimensional network structure. It is suitable to use here an organohydrogenpolysiloxane in which the number of silicon atoms on the molecule (or the degree of polymerization) is from 2 to 300, and especially about 4 to 200, and which is thus liquid at room temperature. The silicon-bonded hydrogen atoms (SiH groups) included on the organohydrogenpolysiloxane may be positioned at the ends of the molecular chain, on side chains, or both. The organohydrogenpolysiloxane has at least two (typically 2 to 300), preferably 3 or more (e.g., 3 to 200), and more preferably 4 to 150, SiH groups per molecule.

Illustrative examples of the organohydrogenpolysiloxane include 1,1,3,3-tetramethyldisiloxane, 1,3,5,7-tetramethylcyclotetrasiloxane, methylhydrogencyclopolysiloxane, methylhydrogensiloxane-dimethylsiloxane cyclic copolymers, tris(dimethylhydrogensiloxy)methylsilane, tris(dimethylhydrogensiloxy)phenylsilane, methylhydrogenpolysiloxane capped at both ends with trimethylsiloxy groups, dimethylsiloxane-methylhydrogensiloxane copolymers capped at both ends with trimethylsiloxy groups, dimethylpolysiloxane capped at both ends with dimethylhydrogensiloxy groups, dimethylsiloxane-methylhydrogensiloxane copolymers capped at both ends with dimethylhydrogensiloxy groups, methylhydrogensiloxane-diphenylsiloxane copolymers capped at both ends with trimethylsiloxy groups, methylhydrogensiloxane-diphenylsiloxane-dimethylsiloxane copolymers capped at both ends with trimethylsiloxy groups, cyclic methylhydrogenpolysiloxane, cyclic methylhydrogensiloxane-dimethylsiloxane copolymers, cyclic methylhydrogensiloxane-diphenylsilane-dimethylsiloxane copolymers, copolymers consisting of (CH₃)₂HSiO_{1/2} units and SiO_{4/2} units, copolymers consisting of (CH₃)₂HSiO_{1/2} units, SiO_{4/2} units and (C₆H₅)SiO_{3/2} units, and any of the foregoing compounds in which some or all of the methyl groups are substituted with other alkyl groups such as ethyl or propyl, or with aryl groups such as phenyl.

The content of the organohydrogenpolysiloxane per 100 parts by weight of the organopolysiloxane serving as component (A) is preferably 0.1 to 30 parts by weight, more preferably 0.1 to 10 parts by weight, and even more preferably 0.3 to 10 parts by weight.

Moreover, this organohydrogenpolysiloxane is preferably included in an amount such that the molar ratio of silicon-bonded hydrogen atoms (SiH groups) in component (C) to silicon-bonded alkenyl groups in component (A) is preferably 0.5 to 5 mol/mol, more preferably 0.8 to 4 mol/mol, and even more preferably 1 to 3 mol/mol.

The hydrosilylation catalyst used for crosslinking in (a) the addition reaction (hydrosilylation) type curing agent may be a known catalyst, examples of which include platinum catalysts such as platinum black, platinic chloride, chloroplatinic acid, reaction products of chloroplatinic acid with monohydric alcohols and complexes of chloroplatinic acid with olefins, palladium catalysts, and rhodium catalysts. The hydrosilylation catalyst may be included in a catalytic amount. The content, expressed in terms of the weight of the platinum group metal, is preferably in the range of 1 to 100 ppm, and especially 5 to 100 ppm. At less than 1 ppm, the addition reaction may not proceed to a sufficient degree, resulting in undercure. On the other hand, the addition of more than 100 ppm may not be cost-effective.

In addition to the reaction catalyst, an addition reaction regulator may be used for the purpose of adjusting the curing rate or the pot life. Examples of such regulators include ethynylcyclohexanol and tetramethyltetravinylcyclotetrasiloxane.

Illustrative examples of the organic peroxides (b) include benzoyl peroxide, 2,4-dichlorobenzoyl peroxide, p-methylbenzoyl peroxide, o-methylbenzoyl peroxide, 2,4-dicumylperoxide, 2,5-dimethylbis(2,5-t-butylperoxy)hexane, di-t-butylperoxide, t-butylperbenzoate and 1,6-hexanediol bis(t-butylperoxy)carbonate.

The organic peroxide (b) is added in an amount, per 100 parts by weight of component (A), of preferably 0.1 to 15 parts by weight, and more preferably 0.2 to 10 parts by weight. When too little is added, the crosslinking reaction may not proceed to a sufficient degree, the hardness may decrease and the rubber strength may be inadequate. On the other hand, adding too much may not only be undesirable in terms of cost, but may also generate a large amount of curing agent decomposition products and increase sheet discoloration.

Component (D), which is added to improve the adhesive strength of the silicone adhesive sheet to the solar cell panel and solar cells, or to a backsheet whose surface is made of fluoroplastic, is preferably a compound containing at least one alkoxy, epoxy, acrylic or methacrylic group. The amount of component (D) added per 100 parts by weight of component (A) is preferably 0 to 10 parts by weight, more preferably 0.01 to 8 parts by weight, and even more preferably 0.2 to 5 parts by weight. Illustrative examples of component (D) include the compounds shown below.

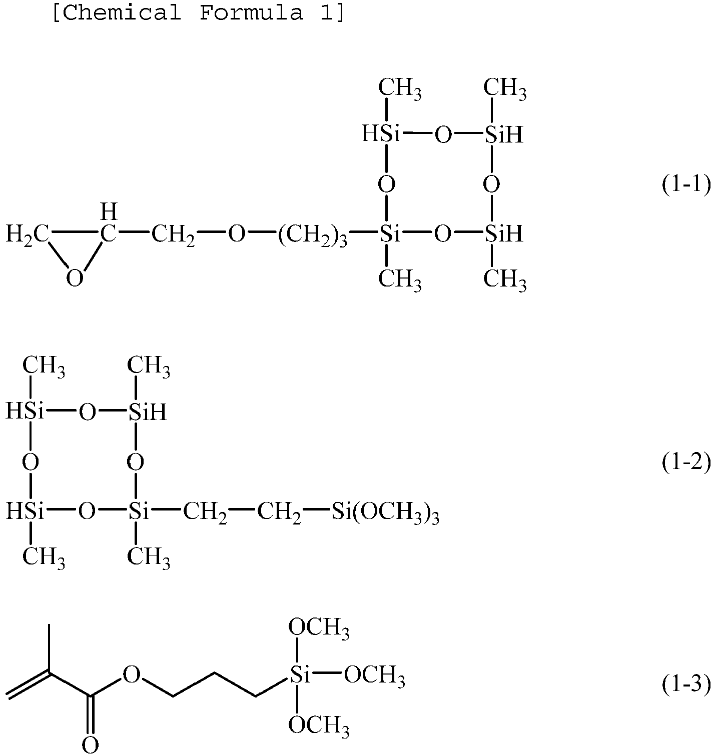

Adding a small amount of such a tackifier is thought to increase adhesion to the glass that is widely used as the light-receiving surface panel, to the solar cell surface (SiN film) that is likewise a ceramic and to the back surface electrode (Al), and to maintain adhesion after standing in an accelerated deterioration test under conditions of, for example, 85°C and 85% RH. Even in cases where these tackifying ingredients are added to (a) an addition reaction (hydrosilylation) system, the total amount of organohydrogenpolysiloxane in components (C) and (D) is preferably such that the molar ratio of silicon-bonded hydrogen atoms (SiH groups) in components (C) and (D) to silicon-bonded alkenyl groups in components (A) and (D) is preferably from 0.5 to 5 mol/mol, more preferably 0.8 to 4 mol/mol, and even more preferably 1 to 3 mol/mol.

Component (E) is a filler which is added to shield or reflect ultraviolet light. This does not include the reinforcing silica serving as component (B). The filler used as component (E) preferably has a cumulative volume mean particle size d50 (or median size), as determined by the laser diffraction scattering method, of 0.1 to 10 µm. At a particle size smaller than 0.1 µm, the light shielding properties may decrease, whereas at a particle size larger than 10 µm, the filler may scratch the solar cells. Examples of the filler serving as component (E) include crystalline silica, fused silica, titanium oxide, zinc oxide, calcium carbonate, kaolinite, carbon black and iron oxide. Titanium oxide is preferred on account of its electrical insulating properties and its ability to effectively shield ultraviolet light. The amount of addition per 100 parts by weight of component (A) is preferably 0.1 to 50 parts by weight. When titanium oxide having high shielding properties is added, the addition of 0.1 to 5 parts by weight is preferred. When less than 0.1 part by weight is added, ultraviolet light may pass through the silicone adhesive sheet.

Component (F) is an organic ultraviolet absorber which is added so as to absorb UV radiation and keep it from passing through the silicone adhesive sheet. Many benzotriazole, hydroxyphenyltriazine and malonate-based ultraviolet absorbers are commercially available. Ultraviolet absorbers each have characteristic absorption properties. However, because the object in the present application is to prevent deterioration of the resin, particularly PET, situated in the surface layer of the backsheet, a suitable amount of an ultraviolet absorber that absorbs light having a wavelength of 380 nm or less must be added. Examples of component (F) include TINUVIN 326 and TINUVIN 328 (BASF), and RUVA-93 (Otsuka Chemicals Co., Ltd.). In addition, an optical stabilizer (HALS) may also be used together, provided that doing so does not adversely affect curing. The amount thereof included per 100 parts by weight of component (A) is preferably from 0.05 to 2 parts by weight, and especially 0.1 to 0.5 part by weight.

In addition to the above ingredients, other additives such as flame retardants and colorants may also be included in the silicone rubber composition of the invention, provided that this does not compromise the objects of the invention.

The silicone rubber composition of the invention may be obtained by mixing predetermined amounts of the above components on a two-roll mill, kneader, Banbury mixer or the like.

The silicone rubber composition thus prepared has a plasticity of 150 to 1,000, preferably 200 to 800, and more preferably 250 to 600. At a plasticity lower than 150, the uncured sheet has poor shape retention and a strong tack, making it difficult to use. On the other hand, at a plasticity higher than 1,000, the composition is crumbly and difficult to form into a sheet. Measurement of the plasticity may be carried out by the plasticity measurement method described in JIS K 6249.

When the silicone rubber composition of the invention is formed into a sheet, examples of processing methods that may be used include, but are not particularly limited to, extrusion and calendering. The resulting silicone adhesive sheet has a thickness of preferably 0.3 to 2.5 mm, and more preferably 0.3 to 1.0 mm. When the sheet is thinner than 0.3 mm, it may be difficult to seal surface irregularities in the extraction electrode and busbar electrode without leaving gaps in the subsequent heat curing and solar cell encapsulation step. On the other hand, at a thickness greater than 2.5 mm, the increased weight of the adhesive sheet results in an increased module weight.

Unlike a solar cell EVA sheet having a smooth, dry surface, the silicone adhesive sheet of the invention is in an uncured state and thus has surface tack and is deformable. Hence, when forming the composition into a sheet, it is preferable to apply a laminate film to at least one surface so that the sheet does not stick to itself when wound into a roll. The laminate film is peeled off later on during module fabrication. By using an embossed film at this time, the front surface and back surface can be embossed.

The method of fabricating a solar cell module according to the invention is described below. Module fabrication is composed primarily of four steps: i) forming a light-receiving surface panel laminate, ii) forming a backsheet laminate for the back surface side, iii) joining together the panel laminates from steps i) and ii), and iv) encapsulating the solar cells using a vacuum laminator.

Here, the light-receiving surface panel is a transparent member that serves as the side on which sunlight is incident. It must have a good transparency, weather resistance and impact resistance because it is exposed outdoors for a long period of time. Examples of the light-receiving surface panel include colorless tempered glass, acrylic resin, fluoroplastic and polycarbonate resin. Colorless tempered glass having a thickness of about 3 to 5 mm is especially preferred. As for the back surface panel (backsheet on back surface side), which is the surface on the side opposite to where sunlight is incident, use may be made of the laminates referred to as "TPT" (polyvinyl fluoride (PVF)/adhesive/polyethylene terephthalate (PET)/adhesive/PVF) and "TPE" (PVF/adhesive/PET/adhesive/EVA) or, especially, a "PVF/adhesive/PET" laminate. The PET may be a single layer; in any case, it is preferable for PET to be included.

The module fabrication steps are each described below.

### [Step i]

The subsequently described unvulcanized silicone adhesive sheet is placed on a light-receiving surface panel and strings of 2 to 60 connected solar cells are attached thereto with their light-receiving surfaces on bottom, thereby giving a light-receiving surface panel laminate. The solar cells used here may be composed of one or two types of silicon semiconductors selected from among monocrystalline silicon and polycrystalline silicon. The solar cell strings here may be, for example, solar cell assemblies obtained by interconnecting solar cells with tab wires. The silicone adhesive sheet used here may or may not be the UV-shielding silicone adhesive sheet of the invention. For example, use may be made of a sheet produced from a silicone rubber composition similar to the above-described silicone rubber composition but not containing components (E) and (F).

### [Step ii]

The UV-shielding silicone adhesive sheet according to the invention is attached to a backsheet, thereby giving a back surface panel laminate.

### [Step iii]

The light-receiving surface panel laminate is attached to the back surface panel laminate such that the cell back surfaces of the former are in contact with the silicone adhesive sheet of the latter.

### [Step iv]

The light-receiving surface panel/back surface panel laminate fabricated in Step iii is set in a vacuum laminator, deaerated for a given length of time in a reduced-pressure space, and then heated and pressed, thereby encapsulating the solar cells.

Here, when the light-receiving surface panel/back surface panel laminate is placed within a reduced-pressure space, the reduced pressure, although not particularly limited, is preferably from -0.08 to -0.10 MPa. The heating and pressing conditions are selected as appropriate, although heating at 70 to 150°C, particularly 100 to 130°C, and 3 to 5 minutes of vacuum pumping followed by 5 to 30 minutes of pressing at atmospheric pressure is preferred. During pressing, both silicone adhesive sheets crosslink, bonding together the light-receiving surface panel, the silicone adhesive sheet on the light-receiving surface panel, the solar cells, the silicone adhesive sheet on the back surface panel, and the back surface panel. When the heating temperature is lower than 70°C, the curing rate is slow and a complete cure may not be obtained within the molding time. On the other hand, when the temperature is higher than 150°C, the curing rate is rapid and the cure begins during the vacuum pumping period, as a result of which gaps may remain between the silicone adhesive sheet and the light-receiving surface or the back surface panel. For vacuum pumping to be effective, it is helpful here to carry out embossing so as to form a zebra or rhombic texture in the uncured silicone adhesive sheets. The integral body resulting from molding under heat may be post-cured at 100 to 150°C for about 10 minutes to 10 hours.

Once the silicone-encapsulated solar cells have been fabricated into a module by the above steps, an aluminum alloy or stainless steel frame is attached to the periphery of the module and secured with screws or the like, thus providing a completed module that has been conferred with shock resistance.

In this process, the uncured rubber sheet laminated to the light-receiving surface panel may or may not include components (E) and (F) having a UV-shielding effect.

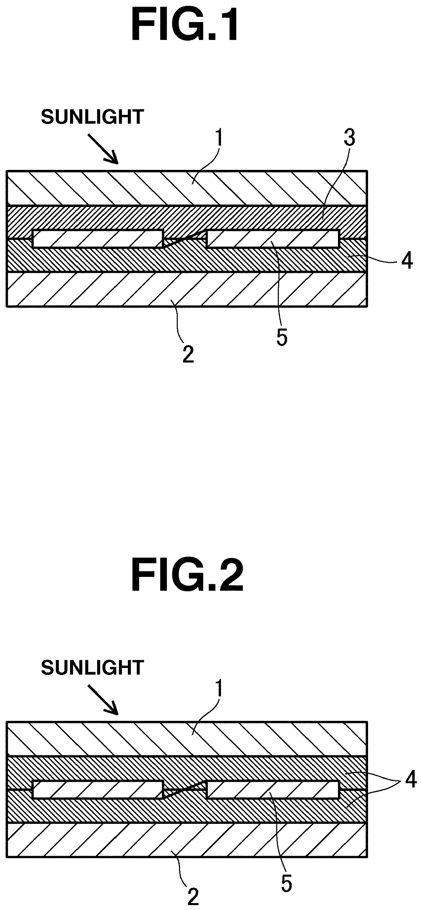

FIG. 1 shows an example in which a solar cell module was formed using, as the uncured rubber sheet laminated to the light-receiving surface panel, a silicone adhesive sheet that does not contain components (E) and (F). FIG. 2 shows an example in which a solar cell module was formed using, as the uncured rubber sheet laminated to the light-receiving surface panel, a UV-shielding silicone adhesive sheet containing component (E) or (F). In the diagrams, 1 is a light-receiving surface panel, 2 is a back surface panel (backsheet), 3 is a non-UV-shielding silicone adhesive cured layer, 4 is a UV-shielding silicone adhesive cured layer, and 5 is a solar cell.

### EXAMPLES

The invention is illustrated more fully below by way of Working Examples and Comparative Examples, although these Examples are not intended to limit the invention.

### [Example 1]

A rubber compound was prepared by combining 100 parts by weight of an organopolysiloxane having an average degree of polymerization of about 8,000 and consisting of 99.825 mol % of dimethylsiloxane units, 0.15 mol % of methylvinylsiloxane units and 0.025 mol % of dimethylvinylsiloxane units, 70 parts by weight of the dry silica Aerosil 300 (Nippon Aerosil Co., Ltd.) having a BET specific surface area of 300 m²/g, 16 parts by weight of hexamethyldisilazane as a dispersant and 4 parts by weight of water, mixing the ingredients in a kneader and heat-treating at 170°C for 2 hours. Next, 1.0 part by weight of the titanium oxide R-820 (Ishihara Sangyo Kaisha, Ltd.) having an average particle size of 0.26 µm, and an addition crosslinking curing agent consisting of 0.5 part by weight of C-25A (a platinum catalyst) and 2.0 parts by weight of C-25B (an organohydrogenpolysiloxane) (both products of Shin-Etsu Chemical Co., Ltd.), after being milled on a two-roll mill, were each added to and uniformly mixed with 100 parts by weight of the resulting compound, giving an uncured UV-shielding silicone rubber adhesive composition.

### [Measurement of Light Transmittance]

The UV-shielding silicone rubber adhesive composition was formed to dimensions of 50 mm × 50 mm × 2 mm (thickness), then heat-cured at 130°C for 30 minutes, and the transmittance to 380 nm light was measured with a U-3310 Spectrophotometer (Hitachi, Ltd.).

### [Evaluation of Backsheet Deterioration by UV Light]

The cured product obtained by curing the above UV-shielding silicone rubber adhesive composition at 130°C for 30 minutes was placed on a PET film (Lumirror, from Toray Industries, Inc.) and on a PC test piece (Panlite, from Teijin Ltd.), each formed to dimensions of 25 mm × 25 mm, and was irradiated with 365 nm ultraviolet light at 120 mW/cm² for 6 hours at 70°C using the Eye Super UV Tester (a super-accelerated weathering tester from Iwasaki Electric Co., Ltd.). The appearance of the PET film and PC test piece were checked at this time.

### [Test Production of Solar Cell Module]

### [1] Production of Silicone Adhesive for Placement on Light-Receiving Surface

A rubber compound was prepared by combining 100 parts by weight of an organopolysiloxane having an average degree of polymerization of about 8,000 and consisting of 99.825 mol % of dimethylsiloxane units, 0.15 mol % of methylvinylsiloxane units and 0.025 mol % of dimethylvinylsiloxane units, 70 parts by weight of the dry silica Aerosil 300 (Nippon Aerosil Co., Ltd.) having a BET specific surface area of 300 m²/g, 16 parts by weight of hexamethyldisilazane as a dispersant and 4 parts by weight of water, mixing the ingredients in a kneader and heat-treating at 170°C for 2 hours. Next, an addition crosslinking curing agent consisting of 0.5 part by weight of C-25A (a platinum catalyst) and 2.0 parts by weight of C-25B (an organohydrogenpolysiloxane) (both products of Shin-Etsu Chemical Co., Ltd.), after being milled on a two-roll mill, was added to and uniformly mixed with 100 parts by weight of the rubber compound, giving an uncured silicone rubber adhesive composition.

This silicone rubber adhesive composition was formed into a 0.7 mm sheet on a two-roll mill. The resulting silicone adhesive sheet was embossed by pressing the embossing roll surface of a diamond embossing film (Emboss NEF type; thickness, 0.15 mm; from Ishijima Chemical Industries, Ltd.) against each side of the silicone adhesive sheet with a rubber roller so as bond the embossing films to both sides of the silicone adhesive sheet.

### [2] Assembly of Light-Receiving Surface Laminate

The embossing film was peeled from one side of the embossed silicone adhesive sheet, and the sheet was bonded to a 340 mm × 360 mm colorless reinforced glass substrate (Asahi Glass Co., Ltd.; referred to below as the "glass substrate") with a rubber roller.

### [3] Assembly of Back Surface Laminate

Using a single-layer PET film having a thickness of 250 µm as the backsheet, the embossing film was peeled from one side of a UV-shielding silicone adhesive sheet was formed from the uncured silicone rubber adhesive composition having UV-shielding properties and embossed in the same way as described above, following which the UV-shielding silicone adhesive sheet was bonded to the PET film with a rubber roller.

### [4] Assembly of Light-Receiving Surface/Back Surface Laminate

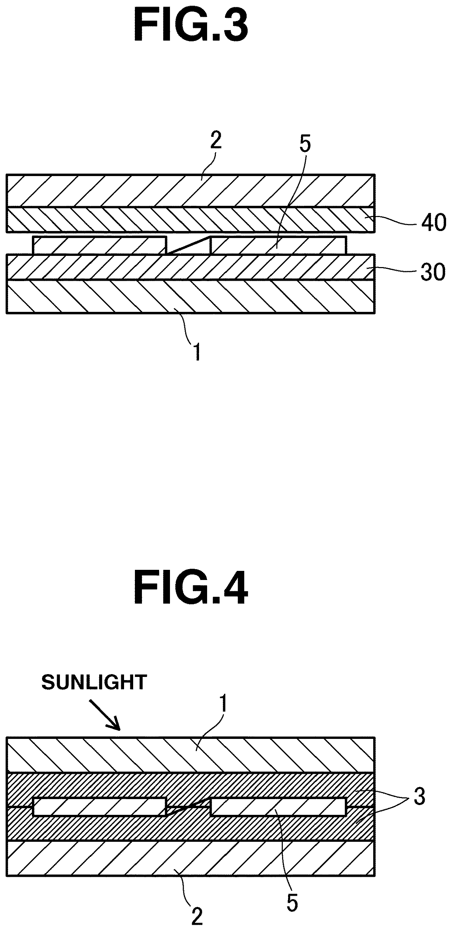

The embossing film was peeled from the other side of the silicone adhesive sheet bonded to the glass substrate, following which a monocrystalline silicon solar cell string of a total of four solar cells vertically and horizontally interconnected in a 2-row, 2-column matrix was placed thereon. In addition, the embossing film was peeled from the other side of the UV-shielding silicone adhesive sheet bonded to the PET film and the peeled surface was placed downward on top of the solar cell string. This gave the light-receiving surface glass/silicone adhesive sheet/solar cell/UV-shielding silicone adhesive sheet/transparent PET light-receiving surface/back surface laminate shown in FIG. 3. In the diagram, 30 is a non-UV-shielding silicone adhesive sheet (uncured) and 40 is a UV-shielding silicone adhesive sheet (uncured).

### [5] Lamination Step

The light-receiving surface/back surface laminate obtained in [4] was placed in a vacuum laminator and, under 110°C heating, was subjected to 3 minutes of vacuum pumping followed by 15 minutes of pressure-bonding at atmospheric pressure, giving a solar cell module. The appearance of this solar cell module was visually evaluated to check for the presence of gaps and cell cracking.

### [Example 2]

An uncured adhesive composition was prepared by adding 0.2 part by weight of the UV absorber TINUVIN 326 (BASF) dissolved under heating in dimethylsilicone oil (KF-96-100cs, from Shin-Etsu Chemical Co., Ltd.) to 100 parts by weight of the rubber compound in Example 1, and adding the same amount of curing catalyst as in Example 1. Testing was carried out in the same way as in Example 1 using this composition.

### [Example 3]

An uncured adhesive composition was prepared by adding 0.25 part by weight of the UV absorber RUVA-93 (Otsuka Chemicals Co.., Ltd.) dissolved under heating in dimethylsilicone oil (KF-96-100cs, from Shin-Etsu Chemical Co., Ltd.) to 100 parts by weight of the rubber compound in Example 1, and adding the same amount of curing catalyst as in Example 1. Testing was carried out in the same way as in Example 1 using this composition.

### [Comparative Example]

In this Example, an uncured adhesive sheet like that placed on the light-receiving surface was bonded to the backsheet. That is, the adhesive sheet was formed from a silicone rubber adhesive composition obtained as follows. A rubber compound was prepared by combining 100 parts by weight of an organopolysiloxane having an average degree of polymerization of about 8,000 and consisting of 99.825 mol % of dimethylsiloxane units, 0.15 mol % of methylvinylsiloxane units and 0.025 mol % of dimethylvinylsiloxane units, 70 parts by weight of the dry silica Aerosil 300 (Nippon Aerosil Co., Ltd.) having a BET specific surface area of 300 m²/g, 16 parts by weight of hexamethyldisilazane as a dispersant and 4 parts by weight of water, mixing the ingredients in a kneader and heat-treating at 170°C for 2 hours. Next, an addition crosslinking curing agent consisting of 0.5 part by weight of C-25A (a platinum catalyst) and 2.0 parts by weight of C-25B (an organohydrogenpolysiloxane) (both products of Shin-Etsu Chemical Co., Ltd.), after being milled on a two-roll mill, was added to and uniformly mixed with 100 parts by weight of the resulting compound. Testing was carried out in the same way as in Example 1. FIG. 4 shows the solar cell module of the Comparative Example.

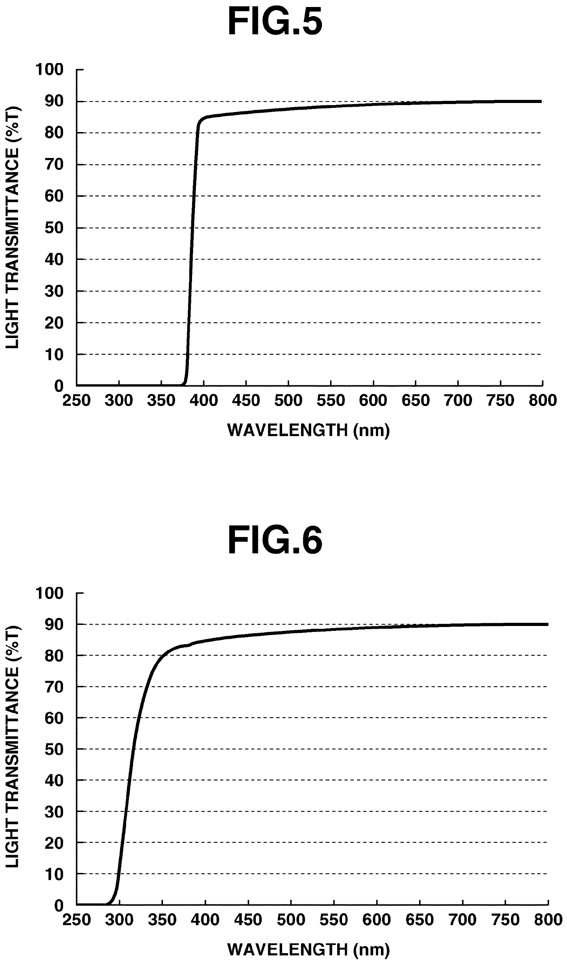

The results are shown in Table 1. FIG. 5 shows the transmittance to light at various wavelengths of the UV-shielding cured silicone adhesive sheet of Example 2, and FIG. 6 shows the transmittance to light at various wavelengths of the silicone adhesive sheet of the Comparative Example.

**[Table 1]**

| | Example 1 | Example 2 | Example 3 | Comparative Example |
|---|---|---|---|---|
| Light transmittance, %T (at 380 nm) | 0 | 0 | 5 | 80 |
| PET appearance after UV degradation test | clear and colorless | clear and colorless | clear and colorless | brown |
| PC appearance after UV degradation test | clear and colorless | clear and colorless | clear and colorless | brown |
| Appearance of solar cell module after molding | good | good | good | good |

The results demonstrate that, by using an adhesive sheet having a low transmittance to 380 nm light, it was possible to prevent the UV degradation of PET and other backsheet members used in solar cells. It was also possible to reliably and effectively seal the solar cells, enabling module productivity to be greatly improved without using conventional difficult-to-handle liquid silicones.

### REFERENCE SIGNS LIST

- 1: Light-receiving surface panel
- 2: Back surface panel (backsheet)
- 3: Non-UV-shielding cured silicone adhesive layer
- 30: Non-UV-shielding uncured silicone adhesive layer
- 4: UV-shielding cured silicone adhesive layer
- 40: UV-shielding uncured silicone adhesive layer
- 5: Solar cell

## Claims

1. A UV-shielding silicone adhesive sheet for encapsulating solar cells that forms, in a solar cell module comprising a light-receiving surface panel, a back surface panel, a silicone adhesive layer in contact with the light-receiving surface panel, a silicone adhesive layer in contact with the back surface panel, and a plurality of solar cells interposed between and encapsulated by both adhesive layers, the silicone adhesive layer in contact with the back surface panel, which UV-shielding silicone adhesive sheet is **characterized by** having a light transmittance, measured as the transmittance to 380 nm wavelength light of the sheet when cured and having a thickness of 2 mm, of not more than 30%,
wherein the silicone adhesive sheet comprises:
(A) 100 parts by weight of an organopolysiloxane of the formula
R¹ₐSiO_{(4-a)/2} (I)
(wherein each R¹, which is the same or different, is an unsubstituted or substituted monovalent hydrocarbon group, and "a" is a positive number from 1.95 to 2.05) having a degree of polymerization of at least 100;
(B) 10 to 150 parts by weight of reinforcing silica having a BET specific surface area of more than 200 m²/g;
(C) a curing agent in an amount effective for curing component (A) ;
(D) 0 to 10 parts by weight of a tackifier; and
(E) 0.1 to 50 parts by weight of a filler having an average particle size (measured as the cumulative volume mean particle size d50 and determined by the laser diffraction scattering method) of 0.1 to 10 µm (exclusive of component (B))or (F) 0.05 to 2 parts by weight of an ultraviolet absorber.

2. The silicone adhesive sheet of claim 1 wherein component (D) contains at least one selected from among alkoxy, epoxy, acrylic and methacrylic group, and which includes at least 0.01 part by weight of component (D) per 100 parts by weight of component (A) .

3. The silicone adhesive sheet of claim 1 or 2 which has a thickness of 0.3 to 2.5 mm.

4. The silicone adhesive sheet of any one of claims 1 to 3 which is embossed on both sides.

5. The silicone adhesive sheet of any one of claims 1 to 4, comprising components (A) to (E) and further comprising (F) 0.05 to 2 parts by weight of an ultraviolet absorber.

6. The silicone adhesive sheet of any one of claims 1 to 5, wherein component (F) is selected from among benzotriazole, hydroxyphenyltriazine and malonate-based ultraviolet absorbers.

7. The silicone adhesive sheet of any one of claims 1 to 6, wherein component (A) is a linear organopolysiloxane having aliphatic unsaturated groups bonded to silicon atoms at the ends of the molecular chain.

8. The silicone adhesive sheet of any one of claims 1 to 7, wherein component (C) is a combination of an organohydrogenpolysiloxane and a hydrosilylation catalyst, or an organic peroxide.

9. The silicone adhesive sheet of any one of claims 1 to 8, wherein component (E) is selected from among crystalline silica, fused silica, titanium oxide, zinc oxide, calcium carbonate, kaolinite, carbon black and iron oxide.

10. A silicone-encapsulated solar cell module obtained by laminating, in order, a light-receiving surface panel, a curable silicone adhesive sheet, a plurality of solar cells, the UV-shielding silicone adhesive sheet of any one of claims 1 to 4 and a back surface panel, and using a vacuum laminator to heat and press the laminate under a vacuum so as to cure both adhesive sheets and encapsulate the solar cells.

11. The solar cell module of claim 10, wherein the back surface panel is a polyethylene terephthalate-containing backsheet.

## Patentansprüche

1. UV-abschirmende Siliconhaftfolie zum Einkapseln von Solarzellen, welche in einem Solarzellenmodul, umfassend eine lichtaufnehmende Oberflächenplatte, eine Rückseitenplatte, eine Siliconhaftschicht in Kontakt mit der lichtaufnehmenden Oberflächenplatte, eine Siliconhaftschicht in Kontakt mit der Rückseitenplatte und eine Vielzahl von zwischen den beiden Haftschichten eingefügten und eingekapselten Solarzellen, die in Kontakt mit der Rückseitenplatte befindliche Siliconhaftschicht bildet, wobei die UV-abschirmende Siliconhaftschicht dadurch charakterisiert ist, dass sie eine Lichtdurchlässigkeit, gemessen als die Durchlässigkeit gegenüber Licht von 380 nm Wellenlänge der Folie nach Härtung und mit einer Dicke von 2 mm, von nicht mehr als 30% aufweist,
wobei die Siliconhaftfolie umfasst:
(A) 100 Gewichtsteile eines Organopolysiloxans der Formel
R¹ₐSiO_{(4-a)/2} (I)
(worin jedes R¹, welches gleich oder verschieden ist, eine unsubstituierte oder substituierte, einwertige Kohlenwasserstoffgruppe ist, und "a" eine positive Zahl von 1,95 bis 2,05 ist) mit einem Polymerisationsgrad von mindestens 100;
(B) 10 bis 150 Gewichtsteile Verstärkungssilica mit einer spezifischen Oberfläche nach BET von mehr als 200 m²/g;
(C) ein Härtungsmittel in einer wirksamen Menge zum Härten der Komponente (A);
(D) 0 bis 10 Gewichtsteile eines Klebrigmachers; und
(E) 0,1 bis 50 Gewichtsteile eines Füllstoffs mit einer durchschnittlichen Teilchengröße (gemessen als die kumulative volumenmittlere Teilchengröße d50 und bestimmt durch die Laserdiffraktions-Streuungsmethode) von 0,1 bis 10 µm (ausgenommen der Komponente (B)) oder
(F) 0,05 bis 2 Gewichtsteile eines Ultraviolettabsorbers.

2. Siliconhaftfolie nach Anspruch 1, wobei Komponente (D) mindestens eine enthält, gewählt aus Alkoxy-, Epoxy-, Acryl- und Methacrylgruppe, und welche mindestens 0,01 Gewichtsteile der Komponente (D) pro 100 Gewichtsteile der Komponente (A) beinhaltet.

3. Siliconhaftfolie nach Anspruch 1 oder 2, welche eine Dicke von 0,3 bis 2,5 mm aufweist.

4. Siliconhaftfolie nach irgendeinem der Ansprüche 1 bis 3, welche auf beiden Seiten geprägt ist.

5. Siliconhaftfolie nach irgendeinem der Ansprüche 1 bis 4, umfassend Komponenten (A) bis (E) und weiterhin umfassend (F) 0,05 bis 2 Gewichtsteile eines Ultraviolettabsorbers.

6. Siliconhaftfolie nach irgendeinem der Ansprüche 1 bis 5, wobei Komponente (F) gewählt ist aus Benzotriazol, Hydroxyphenyltriazin und Malonat-basierten Ultraviolettabsorbern.

7. Siliconhaftfolie nach irgendeinem der Ansprüche 1 bis 6, wobei Komponente (A) ein lineares Organopolysiloxan ist, das aliphatische ungesättigte Gruppen an Siliciumatomen an den Enden der Molekülkette gebunden hat.

8. Siliconhaftfolie nach irgendeinem der Ansprüche 1 bis 7, wobei Komponente (C) eine Kombination aus einem Organohydrogenpolysiloxan und einem Hydrosilylierungskatalysator oder ein organisches Peroxid ist.

9. Siliconhaftfolie nach irgendeinem der Ansprüche 1 bis 8, wobei Komponente (E) gewählt ist aus kristallinem Silica, Quarzglas, Titanoxid, Zinkoxid, Calciumcarbonat, Kaolinit, Ruß und Eisenoxid.

10. Silicon-eingekapseltes Solarzellenmodul, erhalten durch Laminieren, in der Reihenfolge, einer lichtaufnehmenden Oberflächenplatte, einer härtbaren Siliconhaftfolie, einer Vielzahl von Solarzellen, der UV-abschirmenden Siliconhaftfolie nach irgendeinem der Ansprüche 1 bis 4 und einer Rückseitenplatte, und Verwendung eines Vakuum-Laminators zum Erhitzen und Pressen des Laminats unter einem Vakuum, um so die beiden Haftfolien zu härten und die Solarzellen einzukapseln.

11. Solarzellenmodul nach Anspruch 10, wobei die Rückseitenplatte eine Polyethylenterephthalat-enthaltende Rückenplatte ist.

## Revendications

1. Une feuille adhésive de silicone anti-UV pour encapsuler des cellules solaires qui forme, dans un module de cellule solaire comprenant un panneau de surface recevant la lumière, un panneau de surface arrière, une couche d'adhésif de silicone en contact avec le panneau de surface recevant la lumière, une couche d'adhésif de silicone en contact avec le panneau de surface arrière, et une pluralité de cellules solaires interposées entre et encapsulées par les deux couches d'adhésif, la coupe couche d'adhésif de silicone en contact avec le panneau de surface arrière, ladite feuille adhésive de silicone anti-UV étant **caractérisée par** un facteur de transmission de lumière, mesurée comme la transmittance à la lumière de longueur d'onde de 380 nm de la feuille lorsqu'elle est durcie et et lorsqu'elle a une épaisseur de 2 mm, de pas plus de 30%, dans lequel la feuille adhésive de silicone comprend:
(A) 100 parties en poids d'un organopolysiloxane de formule
R1aSiO(4-a)/2 (I)
(dans laquelle chaque R1, qui est le identique ou différent, est un groupe hydrocarboné monovalent non substitué ou substitué, et "a" est un nombre positif de 1,95 à 2,05) ayant un degré de polymérisation d'au moins 100;
(B) 10 à 150 parties en poids de silice renforçante ayant une surface spécifique selon BET supérieure à 200 m2 /g;
(C) un agent de durcissement en une quantité efficace pour le durcissement du composant (A);
(D) 0 à 10 parties en poids d'un agent collant; et
(E) 0,1 à 50 parties en poids d'une charge ayant une taille moyenne de particule (mesurée comme la taille de particule moyenne du volume cumulatif d50 et déterminée par un procédé de balayage de diffraction de laser) de 0,1 à 10 µm (à l'exclusion du composant (B)) ou (F) 0,05 à 2 parties en poids d'un absorbeur d'ultraviolet.

2. La feuille adhésive de silicone selon la revendication 1, dans laquelle le composant (D) contient au moins un composé choisi parmi un groupe alcoxy, époxy, acrylique et méthacrylique, et qui comprend au moins 0,01 partie en poids du composant (D) pour 100 parties en poids de composant (A).

3. La feuille adhésive de silicone selon des revendication 1 ou 2 qui a une épaisseur de 0,3 à 2,5 mm.

4. La feuille adhésive de silicone selon l'une quelconque des revendications 1 à 3, qui est gaufrée des deux côtés.

5. La feuille de silicone adhésive selon l'une quelconque des revendications 1 à 4 comprenant les composants (A) à (E) et en outre (F) 0,05 à 2 parties en poids d'un absorbant d'ultraviolets.

6. La feuille de silicone adhésive selon l'une quelconque des revendications 1 à 5, dans laquelle le composant (F) est choisi parmi le benzotriazole, l'hydroxyphénylhydrazine et les absorbants d'ultraviolets à base de malonate.

7. La feuille de silicone adhésive selon l'une quelconque des revendications 1 à 6, dans laquelle le composant (A) est un polyorganosiloxane ayant des groupes non saturés aliphatiques liés à des atomes de silicium aux extrémités de la chaîne moléculaire.

8. La feuille de silicone adhésive selon l'une quelconque des revendications 1 à 7, dans laquelle le composant (C) est une combinaison d'un organohydrogénopolysiloxane et d'un catalyseur d'hydrosilylation, ou un peroxyde organique.

9. La feuille de silicone adhésive selon l'une quelconque des revendications 1 à 8, dans laquelle le composant (E) est choisi parmi la silice cristalline, la silice fondue, l'oxyde de titane, l'oxyde de zinc, le carbonate de calcium, la kaolinite, le noir de carbone et l'oxyde de fer.

10. Un module de cellule solaire à encapsulation de silicone obtenu en stratifiant, dans l'ordre, un panneau de surface recevant la lumière, une feuille adhésive en silicone durcissable, une pluralité de cellules solaires, la feuille adhésive en silicone anti-UV de l'une quelconque des revendications 1 à 4 et un panneau de surface arrière, et en utilisant un laminateur sous vide pour chauffer et presser le stratifié sous vide de manière à durcir les deux feuilles adhésives et encapsuler les cellules solaires.

11. Le module de cellule solaire selon la revendication 10, dans lequel le panneau de surface arrière est une feuille de fond contenant du téréphtalate de polyéthylène.
